(19) **Europäisches Patentamt**
**European Patent Office**
**Office européen des brevets**

(11) **EP 4 295 415 B1**

(12) **EUROPEAN PATENT SPECIFICATION**

(45) Date of publication and mention
of the grant of the patent:
**02.04.2025 Bulletin 2025/14**

(21) Application number: **21968419.8**

(22) Date of filing: **20.12.2021**

(51) International Patent Classification (IPC):
*H02S 40/42* (2014.01)    *H01L 31/048* (2014.01)

(52) Cooperative Patent Classification (CPC):
**H02S 40/42; H10F 19/807;** Y02E 10/50

(86) International application number:
**PCT/CN2021/139720**

(87) International publication number:
**WO 2023/115263 (29.06.2023 Gazette 2023/26)**

(54) **SOLAR MODULE WITH PASSIVE COOLING STRUCTURE, METHOD FOR PRODUCTION THEREOF AND USE THEREOF**

SOLARMODUL MIT PASSIVER KÜHLSTRUKTUR, VERFAHREN ZU DESSEN HERSTELLUNG UND DESSEN VERWENDUNG

MODULE SOLAIRE À STRUCTURE DE REFROIDISSEMENT PASSIF, SON PROCÉDÉ DE PRODUCTION ET SON UTILISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.12.2023 Bulletin 2023/52**

(73) Proprietors:
• **Triumph Science & Technology Group Co., Ltd**
**Beijing 100036 (CN)**
• **CNBM RESEARCH INSTITUTE FOR ADVANCED GLASS**
**MATERIALS GROUP CO., LTD.**
**Bengbu, Anhui 233010 (CN)**

(72) Inventors:
• **PALM, Joerg**
**81739 Munich (DE)**
• **BOROWSKI, Peter**
**81739 Munich (DE)**

(74) Representative: **Staeger & Sperling**
**Partnerschaftsgesellschaft mbB**
**Sonnenstraße 19**
**80331 München (DE)**

(56) References cited:
WO-A1-2014/075919    CN-U- 204 303 844
CN-U- 205 050 856    CN-U- 206 628 494
US-A1- 2008 135 085    US-A1- 2008 135 092
US-A1- 2010 186 806    US-A1- 2013 255 765
US-A1- 2016 204 296

**Description**

**Technical Field**

The present application relates to the technical field of solar energy, and in particular to a solar module with a passive cooling structure, a method for production thereof and use thereof.

**Background**

A photovoltaic layer system for the production of solar cells is well known in the art, for example through commercially available solar modules. Materials of layers in the system, in particular a semiconducting material of an absorber layer for photoelectric conversion, are selected in such a way that incident sun's rays can be converted into electrical current in a satisfactory efficiency. Due to the physical properties and the technological manageability, the absorber layer made of amorphous, micromorphous or polycrystalline silicon, cadmium telluride (CdTe), gallium arsenide (GaAs), copper indium gallium disulfide diselenide ($Cu(In,Ga)(S,Se)_2$), copper-zinc-tin-sulfo-selenide (CZTS from the kesterite group) and organic semiconductors is particularly suitable for (thin-film) solar cells. The pentanary semiconductor $Cu(In,Ga)(S,Se)_2$, which belongs to the chalcopyrite compound semiconductor group, is particularly important in the industrial mass production of solar modules.

In practical application, the solar modules may be installed on a roof of a building (on-roof installation) or form part of a surface of the roof (in-roof installation). The use of solar modules as facade or wall elements in building-integrated photovoltaic and the use of the solar modules in the form of free-standing or self-supporting (carrier-free) glass constructions are also known.

In the solar module, only part of the incident light radiation is converted into electrical energy and the rest of the incident light radiation is converted directly into heat. The heating of the solar module depends on external influences such as ambient temperature and wind speed as well as on the specific structure of the solar module. In particular, the building-integrated solar module will get very hot if the heat generated by the solar module cannot be adequately dissipated. An uncontrolled release of the heat to the facade of the building is undesirable, as the building would heat up in an unacceptable manner in summer. In general, there is a thermal insulating layer at a wall side of the ventilated facade of the building in order to achieve adequate thermal insulation in winter.

In addition, the electrical output of the solar module decreases when the internal temperature of the solar module and the semiconductor structure increases during operation. This property of the solar module is described by the temperature coefficient Tk, which indicates the relative change in the efficiency or the electrical output (in %) as a function of the temperature (in K). The temperature coefficient Tk depends essentially on the used semiconductor structure, and for example, varies between -0.4%/K (solar module made of crystalline or multicrystalline silicon) and -0.28%/K (CdTe solar module). The solar module based on $Cu(In,Ga)(S,Se)_2$ has generally a temperature coefficient of about -0.35%/K. For example, if the temperature is increased by 40K, the electrical output is reduced by 14% relative to the previous electrical output.

The temperature increase of the solar module during operation may be described simply by the following formula:

$$T_{cell} = T_{amb} + 1/U \times (\alpha \times G_{inc} \times (1 - \eta(T_{cell})))$$

where:

$$\eta\,(T_{cell}) = \eta\,(25°C) \times (1 + \delta \times (T_{cell}\text{-}25°C))$$

$T_{amb}$: ambient temperature
$G_{inc}$: radiated power
$\alpha$: absorption coefficient of solar radiation, i.e. (1 - reflection)
$\eta$: efficiency (indicates the energy extracted from the solar module)
$\delta$: relative temperature coefficient of efficiency
U: heat transfer coefficient.

The heat transfer coefficient U depends on the thermal volume properties of the solar module (thermal conductivity) and the transfer of heat to the environment (heat transfer coefficient). The heat transfer coefficient is further divided into a conductive component, which depends on the external wind speed, and a radiation component. The heat transfer coefficient U is the inverse of the heat transfer resistance RT.

The above formula shows that the increase in the electrical efficiency results in the reduction of the thermal power loss and thus the reduction of the increase in temperature. However, the increase in the electrical efficiency can be only achieved in a comparatively small step with a high level of technical effort. Even the increase in the efficiency of the solar module from 15% to 20% only results in the decrease in thermal energy of 6%. The absorption coefficient of solar radiation $\alpha$ should not be reduced, as the reduction of $\alpha$ would reduce the overall efficiency and yield of the solar module. An improved heat transfer coefficient U means better cooling of the solar module.

However, there are other conditions that must be taken into account for efficient cooling of the solar module, such as the cost, the weight and the long-term stability of the solar module.

For example, in case of a temperature coefficient Tk of -0.35%/K (for a solar module based on $Cu(In,Ga)(S,Se)_2$), the improved cooling of the solar module results in a relative improvement in efficiency of 7%, while reducing the operating temperature of the solar module by 20°C. Therefore, the material requirements and the costs for cooling the solar module should not exceed the added value in terms of electrical output. Furthermore, the weight of the solar module must also be taken into account. An increase in weight by for example more than 20 kg is problematic, since the installation of the solar module is usually done manually by installation personnel, which would not only increase the personnel cost, but also bring about the demands on the installation structure. The long-term stability of the solar module must also be taken into account. The solar module is typically operated at a system voltage of 1000 V to 1500 V. As described in WO 2015004244 A1, the interaction of high voltage, high humidity and high temperature triggers a potential-induced degradation (PID effect), which reduces the electrical output of the solar module. Surprisingly, the very high electrical insulation of the glass is not enough to avoid the PID effect. As described in the aforementioned document, the PID effect can be effectively prevented if the installation structures such as frames or back rails are high electrically insulated.

In the prior art, there are various approaches for cooling solar modules. The "Innovative methods of cooling solar panel: A concise review", Olawole et al., 2019, J. Phys.: Conf. Ser. 1299 012020, gives an overview of the approaches for cooling solar modules. The passive or active cooling approaches can be used for cooling solar modules. In the active cooling approaches, a liquid or gaseous cooling medium is moved by a device such as a pump or a fan to cool the solar modules. In the passive cooling approaches, the heat is only released passively to the environment, without the use of the device for moving the cooling medium.

Many patent documents like for example document WO 2014075919 A1, elating to the cooling of solar modules describes various approaches for cooling solar modules by liquid medium. Furthermore, the PV/T hybrid module, which is well known to those skilled in the art, is also a possible approach. In this approach, the excess heat from the solar module (PV) is dissipated by the solar thermal collector (T) and can be used for heating. The combination of photovoltaics and solar thermal energy is, however, technically very complex, since lines for cooling the medium have to be provided. In addition, a compromise has to be made between heat and electricity, and the heat and electricity generated cannot usually meet the actual needs in buildings.

A combination of a solar module with a thermocouple is a possible approach. For example, GB2384113A describes an approach for either actively cooling the solar module or using the temperature difference to generate additional electrical output. Further, an innovative approach is the use of phase change materials, although no industrial implementation is known yet.

## Summary

The object of the present application is to enable sufficient passive cooling of a solar module. Further, the object of the present application is to enable the solar module to have a high long-term stability independent of external environmental influences and a low weight. In addition, the object of the present application is to enable the solar module to be manufactured simply and cheaply in industrial production.

These and other objects are achieved according to a solar module with a passive cooling structure according to the independent claim 1.

Preferable embodiments of the present application are defined in dependent claims.

An embodiment of the present application provides a solar module with a passive cooling structure. The solar module comprises a front glass and a rear glass, which are fixedly connected to one another by at least one intermediate layer. A plurality of solar cells connected in series are arranged between the front glass and the rear glass. The front glass and the rear glass are each made of glass, particularly soda-lime glass. The front glass forms the front side of the solar module. The front side of the solar module indicates a side of the solar module which, when installed, faces the incident sun's rays. The rear glass forms the back side of the solar module. The back side of the solar module indicates a side of the solar module which, when installed, faces away from the incident sun's rays.

The solar cells may be any solar cells suitable for glass/glass solar modules, in particular thin-film solar cells or silicon wafer cells. A (thin-film) solar module with a composite pane structure is preferable. The (thin-film) solar module has a transparent cover plate made of glass and a rear substrate made of glass, which are fixedly connected to each other by a thermoplastic or cross-linking polymer intermediate layer (e.g. PVB or EVA).

The thin-film solar module may be based on a substrate configuration in which the layer system for forming the thin-film solar cells is applied to a light-incident-side surface of the rear substrate. In this case, the rear substrate serves as a carrier for the layer system. Likewise, the thin-film solar module may be based on a cover plate configuration in which the layer system is applied to a surface of the front cover plate opposite to a light-incident-side surface of the front cover plate. In this case, the front cover plate serves as a carrier for the layer system.

The solar module according to the present application is in particular a glass/glass solar module with thin-film solar cells based on the substrate configuration. In particular, the semiconductor layer is based on copper indium gallium disulfide diselenide $(Cu(In,Ga)(S,Se)_2)$. The solar module is preferably frameless.

In the embodiment of the present application, the passive cooling structure is arranged on the surface of the rear glass away from the solar cells. The passive cooling structure comprises one or more heat sinks, in particular consists of the one or more heat sinks. The passive cooling structure is preferably adhered to the rear glass by means of an adhesive layer. The passive cooling structure is free of any device used to move a liquid or gaseous cooling medium to cool the solar module. The heat generated by the solar module is passively released to the external environment through the passive cooling structure via convection.

The passive cooling structure has a contact surface at which the passive cooling structure is in thermal contact with the rear glass for heat transfer. The contact surface covers at least 90% of a photovoltaically active surface of the solar module. The passive cooling structure is fixedly connected to the rear glass in direct thermal contact with the latter over the entire surface as far as possible.

The one or more heat sinks each consist of a material that has a ratio of thermal conductivity and density of at least 0.02 W•cm$^2$/(g•K), preferably at least 0.05 W•cm$^2$/(g•K). The one or more heat sinks are a part of the passive cooling structure that ensures the convective heat transfer to the environment. An area ratio of the surface of the passive cooling away from the rear glass and the contact surface is at least 3, preferably at least 5, and in particular preferably larger than 7.

By means of the solution of the present application, the heat generated by the solar module can be released passively and efficiently by convection to the external environment, so that the solar module can be cooled excellently during operation. Furthermore, a heat transfer coefficient of the solar module is preferably at least 20 W/(K•m$^2$). Specifically, the passive cooling structure is preferably designed in such a way that a heat transfer coefficient at the contact surface is at least 20 W/(K•m$^2$).

In addition, the passive cooling structure has a mass area density that is a mass of the cooling structure per contact area, and that is smaller than 0.6 g/cm$^2$, preferably smaller than 0.5 g/cm$^2$, and in particular preferably smaller than 0.4 g/cm$^2$. In this way, a relatively small increase in the weight of the solar module due to the cooling structure can be achieved advantageously.

Furthermore, the passive cooling structure is designed or connected to the rear glass of the solar module, so that a resistive area product of the passive cooling structure that is a product of an electrical contact resistance and a contact area between the passive cooling structure and the rear glass, is larger than $4\times10^{11}$ ohm•cm$^2$, preferably larger than $2\times10^{12}$ ohm•cm$^2$, and in particular preferably larger than $1\times10^{13}$ Ohm•cm$^2$. In this way, the potential-induced degradation (PID effect) can be effectively prevented.

Therefore, the solar module according to the present application can be passively and efficiently cooled by the passive cooling structure, with a temperature-induced power loss being considerably reduced. In addition, the PID effect and the associated power loss of the solar module can be avoided. Furthermore, the passive cooling structure only brings about the relatively small increase in the weight of the solar module with the passive cooling structure, so that the solar module can still be installed by means of conventional installation elements (e.g. frame, back rail(s), installation bracket(s)).

As stated above, the passive cooling structure may have only a single heat sink or a plurality of heat sinks (separated from one another). The terms "contact surface", "mass area density" and "resistive area product" each is directed to the entire passive cooling structure, not to individual heat sinks.

The cooling of the solar module according to the present application is based on a suitable cooling structure with a low mass area density and a high electrical insulating connection to the solar module. Essentially the solar module is efficiently cooled only by free convection. The passive cooling has the advantage over the aforementioned active cooling that the complexity of design and installation of the passive cooling structure is significantly lower. Thus, the passive cooling structure has the advantage of cost optimization, in addition to weight reduction. The solar module with the passive cooling structure according to the present application is applicable to all common application domains and installation types such as open space, roof installation or facade installation (as part of a ventilated facade). In particular, the solar module may be used in ventilated facades.

The passive cooling structure has a finely structured surface that faces away from the rear glass and is significantly larger than the contact surface parallel to the rear glass. Advantageously, the contact surface has approximately the same size as the entire area of the solar cells.

As discovered by the invertors on the basis of a precise analysis of the underlying thermal problems, the heat transfer is not determined by heat conduction through the layers of the solar module, but by the heat transfer coefficient U.

The following is applied to a simplified building of a combination of outer and inner walls:

$$1/U = R_T = R_{SE} + d/\lambda + R_{si}$$

where $R_{SE}$ and $R_{si}$ indicate the heat transfer resistances of the outer or inner walls, respectively, and d indicates the thickness of the wall with thermal conductivity $\lambda$.

In a glass-glass solar module, the contribution of the heat conduction or the heat transfer resistance is essentially given by the two glass plates. For example, in case of a total thickness of d = 4mm and a thermal conductivity $\lambda$ of the glass of 0.8 W/K•m, $d/\lambda$ = 0.005 $m^2$•K/W. The contribution of the heat transfer resistance is distinctly higher: for a flat glass composite, the DIN standard EN ISO 6946 specifies values from 0.04 to 0.17 $m^2$•K/W.

The main object of the present application is to increase the heat transfer coefficient for the glass-glass solar module (i.e. to reduce the heat transfer resistance) while meeting the practical requirements for cost, weight and long-term stability. The heat transfer resistance is made of the contributions of convection and radiation. The emissivity of the outer surface is decisive to the proportion of radiation. The glass already has a relatively high emissivity of about 0.84. However, the proportion of radiation at the relevant temperature (40-70 °C) is small. Therefore, the potential for improvement of the contribution of convection is greater.

The requirement with regard to the insulation resistance of a grounded metal body for assembly (e.g. back support (back rail) or frame) has been described as follows in WO2015004244 A1 mentioned above: if the adhesive surface is up to 5% of the solar module surface of $1m^2$ and the thickness of an adhesive for bonding the metal body to the back of the solar module is 1 mm, the specific resistance of the adhesive connection to the glass surface must be at least 5000 GOhm•cm, which corresponds to an electrical resistance of 1 GOhm for the dimensions mentioned. The technical teaching from WO2015004244 A1 cannot, however, simply be transferred to the problem of the high insulating connection of the passive cooling structure. It is not clear what requirements the large metal surface would have to be attached to the solar module, nor is the problem of moisture (dew, moisture condensation and wetness from rain) discussed. In addition, the above document does not provide any information on how to deal with conductive bodies that are not directly grounded at the back side of the solar module.

The moisture can reach the back side of the solar module through condensation or through rainwater. The rainwater has an average conductivity of 50 $\mu$S/cm, i.e. a specific resistance of 20 kOhm•cm, which is 8 orders of magnitude above the required specific conductivity of the adhesive. In the case of contamination, the specific conductivity can be 9 orders of magnitude higher than the required specific conductivity of the adhesive. From various literature sources and investigations, the inventors were able to deduce that, for example, a typical amount of morning dew has a water height of about 0.01 to 0.1 mm. Even this small height corresponds to a sheet resistance of 2 to 20 MOhm per square. The resistance parallel to the glass surface is therefore 1 to 10 MOhm. The contact resistance of the entire glass surface is 1 to 2 GOhm (100 to 1000 times larger than the sheet resistance) depending on the temperature. The thin water layer is almost an equipotential surface compared to the glass surface and forms a second leakage current path of the same order of magnitude as the path through the adhesive surface, which is a factor of 20 smaller than the water layer, and the glass surface underneath. The unpublished studies by the inventors have shown that leakage currents through the glass actually occur both in the climatic chamber and in the open space at higher temperatures and condensed moisture. At the same temperature, the leakage currents are even significantly larger than those through the adhesive surface due to the large glass surface.

At a fixed voltage (system voltage, e.g. 1000 V), the electrical resistance corresponds to an ion current or leakage current and at a fixed time (e.g. required lifetime of the solar module), the electrical resistance corresponds to a certain amount of charge, which leads to a certain degradation of the power per area. For example, since the solar module is installed on a grounded installation system with brackets or back rails, if the insulation resistance between a conductive surface and the back of the module is not high enough, any other conductive surfaces on the back of the solar module might also be long-termly degraded due to the cross line over the conductive surface and the water bridge between the installation system and the conductive surface. A device for improved passive cooling of the solar module must therefore also have a sufficiently high electrical resistance between the outer surface of the heat sink and the inside of the module. The specific resistance of soda lime glass has an exponential relationship with temperature. At room temperature, the specific resistance is the same order of magnitude as that of a typically used adhesive ($\sim 10^{13}$ Ohm•cm). In most technical contexts, the glass may be used as a very good insulating material. However, the specific resistance is not sufficient to guarantee long-term stability, because at operating temperature of 60 °C, it is almost two orders of magnitude lower ($\sim 10^{11}$ Ohm•cm). Other materials used in photovoltaics, such as EVA, also have a similarly strong temperature dependency and are therefore not suitable for this application.

The fundamental considerations that are important for the electrical insulation of the passive cooling structure in the present application are as follows:

In the context of the underlying mechanism of ion migration through the glass, the total resistance should not decrease if the adhesive surface is large. In the case that the specific resistance remains the same, as the adhesive surface increases, the total resistance will decrease and the amount of charge leading to the degradation will increase. Therefore, the required specific resistance must be increased with the area ratio of the contact surface to the original back-rail adhesive surface. The specific resistance of the adhesive of 5000 GOhm•cm required for the back-rail problem for the module of $1m^2$ would be no longer enough for a larger conductive surface in permanent grounding. The total charge or the leakage current flowed per module area should not increase throughout the lifecycle. Therefore, a resistance area product, denoted by $R \times A = \rho \times d$, may be a suitable measure. Therefore, for a module with a size of $1m^2$ and a resistance of 2 GOhm, the required resistance area product is 2 GOhm$\times 10^4$ cm$^2$ = $2 \times 10^{13}$ Ohm•cm$^2$.

The passive cooling structure should be isolated laterally from the grounded installation elements. However, if the passive cooling structure covers the area of the solar cells as large as possible (> 90%, better> 95%) to cool the solar cells efficiently and evenly, distances between the passive cooling structure and the installation elements are only a few millimeters to a few centimeters. With the previously considered amounts of moisture, such a distance means a connection resistance of only 10 to 100 kOhm. Furthermore, if the passive cooling structure is not sufficiently insulated, much smaller amounts of moisture could lead to significantly more leakage paths.

As described above, the distances between the passive cooling structure and the grounded installation elements (back rails, installation brackets, possibly frames, or facade brackets (agraffes) are only a few millimeters to 2 cm. Condensation water, rainwater, dust pollutant, air pollutant and so on will occupy these distances. Since the specific conductivity of the condensation water, rainwater, dust pollutant, air pollutant and so on is 8 orders of magnitude higher than the specific conductivity of the adhesive, only very small amounts of the condensation water, rainwater, dust pollutant, air pollutant and so on are sufficient to bring the passive cooling structure to almost earth potential.

In an embodiment of the present application (which refers to a first embodiment as described below and described in Detailed Description), a moisture film must be formed over the entire passive cooling structure in order to lead to larger leakage currents through the passive cooling structure and the glass. This hardly occurs, but the solar module should have a low level of degradation in performance in all climatic zones and in various environmental conditions.

In an embodiment (which refers to a second embodiment as described below and described in Detailed Description) of the present application in which there is an insulation layer between the rear glass and a high electrically conductive passive cooling structure, the large-area passive cooling structure would be brought to almost earth potential simply by a contact bridge over a small insulation path. If the passive cooling structure is not sufficiently insulated, the entire glass surface would contribute to the leakage current. This only needs to bridge a very short distance compared to the conventional solar module with back rails, thereby increasing the probability that such a leakage current bridge occurs.

The high electrical insulation passive cooling structure required in the present application has an advantage that the passive cooling structure can be used to even improve the PID stability in critical climatic and/or environmental conditions compared to a glass/glass solar module, since even in higher temperatures, the electrical resistance of the passive cooling structure can better limit the leakage currents compared to the free glass surface.

For a permanently grounded connection, for example, for a back rail with an adhesive surface of 500cm$^2$ and for a module of 1 m$^2$, an electrical resistance of the adhesive of 2 GOhm has proven to be sufficiently stable in climatic chamber experiments and in long-term outdoor area tests. The full-surface bonding corresponds to a resistance area product of $2 \times 10^{13}$ Ohm•cm$^2$. The likelihood that a conductive connection occurs depends on the actual climatic and environmental conditions. The required insulation value is therefore assumed to be 2%, 10% or 50% of the operating time. This results in that the resistance area product is $4 \times 10^{11}$ Ohm•cm$^2$, preferably $2 \times 10^{12}$ Ohm•cm$^2$ and in particular preferably $1 \times 10^{13}$ Ohm•cm$^2$. A thickness of the insulation layer of 1mm corresponds to a specific resistance of $4 \times 10^{12}$ Ohm•cm, preferably $2 \times 10^{13}$ Ohm•cm and in particular preferably $1 \times 10^{14}$ Ohm•cm. The simulations have shown that in the presence of moisture, the leakage currents can be reduced by almost an order of magnitude with an additional full-surface layer having a thickness of 1 mm and a specific resistance of at least $1 \times 10^{13}$ Ohm•cm.

A suitable passive cooling structure needs to be made of a material with high thermal conductivity, extremely good electrical insulation and low density. In table 1, the material properties of various known materials are summarized in ascending order of thermal conductivities:

Table 1: Essential properties of various materials

| Material | Thermal conductivity W/(K•m) | Specific resistance (Ohm•m) | Density g/cm$^3$ | Ratio of thermal conductivity to density W•cm$^2$/(g•K) |
|---|---|---|---|---|
| polyurethane | 0.2 | 1.00E+13 | 1.2 | 0.002 |
| silicone | 0.2 | 1.00E+13 | 1 | 0.002 |
| glass | 0.8 | 1.00E+13 | 2.5 | 0.003 |
| concrete | 2 | 1.00E+03 | 2.2 | 0.009 |
| marble, basalt | 3.5 | 1.00E+02 | 2.8 | 0.013 |
| thermally conductive polymers | 10 | 5.00E+11... 5.00E+13 | 1.2 | 0.05 |

(continued)

| Material | Thermal conductivity W/(K•m) | Specific resistance (Ohm•m) | Density g/cm$^3$ | Ratio of thermal conductivity to density W•cm$^2$/(g•K) |
|---|---|---|---|---|
| Si$_3$N$_4$ | 30 | 1.00E+12 | 3.3 | 0.091 |
| Al$_2$O$_3$ | 30 | 1.00E+12 | 3.9 | 0.077 |
| MgO | 55 | 5.00E+12 | 3.4 | 0.162 |
| steel | 50 | 1.50E-07 | 7.8 | 0.064 |
| magnesium alloy | 70 | 1.20E-07 | 1.8 | 0.389 |
| BN | 75 | 1.00E+10 | 2 | 0.375 |
| silicon (undoped) | 150 | 5.00E+04 | 2.3 | 0.652 |
| graphite | 150 | 8.00E-04 | 2.2 | 0.682 |
| AlN | 180 | 1.00E+12 | 3.3 | 0.545 |
| aluminum | 220 | 2.60E-08 | 2.7 | 0.815 |
| copper | 400 | 1.80E-08 | 9 | 0.444 |
| silver | 429 | 1.60E-08 | 10.5 | 0.409 |

Only a few materials have the required properties of good thermal conductivity, low density and high insulation resistance. The metal has a very good thermal conductivity, but the metal has a high density and in particular a high electrical conductivity. Aluminum has a good thermal conductivity and a relatively low specific weight, and thus it is widely used for heat sinks.

The association between thermal conductivity and electrical thermal conductivity is broken by the ceramic materials, such as Al$_2$O$_3$, AlN, MgO and BN. Composite materials made of polymers and various insulating fillers such as BN, Al$_2$O$_3$, Si$_3$N$_4$ and SiO$_2$ only have a lower thermal conductivity, but a good insulation and a very low density.

In the solar module with the passive cooling structure according to the present application, the above considerations are taken into account.

The passive cooling structure has a contact surface at which the passive cooling structure is in thermal contact with the rear glass for heat transfer. The contact surface covers at least 90% of a photovoltaically active surface of the solar module.

The area ratio of the surface of the passive cooling structure away from the rear glass to the contact surface is at least 3, preferably at least 5, and in particular preferably larger than 7.

The one or more heat sinks are each made of a material that has a ratio of thermal conductivity and density of at least 0.02 W•cm$^2$/(g•K), preferably at least 0.05 W•cm$^2$/(g•K).

The passive cooling structure has a mass area density that is a mass of the passive cooling structure per contact area, and that is smaller than 0.6 g/cm$^2$, preferably smaller than 0.5g/cm$^2$, and in particular preferably smaller than 0.4 g/cm$^2$.

In order for a temperature distribution to be as uniform as possible, the passive cooling structure should cover at least 90%, preferably 95%, and in particular preferably 100% of the entire area of the solar cells. The passive cooling structure may also cover the entire back surface of the solar module, which corresponds to 105% to 110% of the photovoltaically active surface of the solar module.

The mass area density of the entire passive cooling structure should be smaller than 0.6 g/cm$^2$, preferably smaller than 0.5 g/cm$^2$, and in particular preferably smaller than 0.4 g/cm$^2$.

The resistance area product, i.e. the product of the electrical contact resistance and the contact area between the passive cooling structure and the rear glass, should be larger than $4 \times 10^{11}$ ohm• cm$^2$, preferably larger than $2 \times 10^{12}$ ohm•cm$^2$, and in particular preferably larger than $1 \times 10^{13}$ ohm•cm$^2$.

The passive cooling structure is a three-dimensional structure with an enlarged surface. The area ratio of the surface of the passive cooling structure away from the rear glass to the contact surface is at least 3, preferably at least 5, in particular preferably larger than 7.

The isolation distance between the passive cooling structure and each grounded installation element (frame, back rail, installation bracket) should be 1 mm to 20mm, preferably 2mm to 20mm.

The heat transfer resistance between the solid bodies, i.e. the glass and each heat sink, should be kept as low as possible by a bubble-free, intimate adhesive bond. In the case of plastics, the heat sink is attached to the rear glass without an additional intermediate layer. In the case of ceramic materials, the heat sink is attached to the rear glass by a very thin adhesive layer. The heat transfer resistance from the solar cell to each heat sink is determined by the heat conduction through the rear glass (for glass/glass modules). The sum of the heat transfer resistances should be smaller than 0.01 $m^2 \cdot$K/W if possible. The heat transfer resistance of a plate of float glass having a thickness of 2 mm is, for example, 0.0025 $m^2 \cdot$K/W. The heat transfer resistance of the adhesive layer should be smaller than 0.005 $m^2 \cdot$K/W. There may be interfacial resistances that are minimized by intimate contact in the glass and the heat sinks.

The heat transfer coefficient of the entire solar module is preferably at least 20 W/(K•$m^2$), in particular preferably 40 W/(K•$m^2$) and most preferably more than 50 W/(K • $m^2$).

According to the first embodiment of the solar module according to the present application, the passive cooling structure comprises one or more heat sinks. There is no insulation layer between the heat sinks and the rear glass. The contact surface for the heat transfer is formed by the one or more heat sinks. If there are a plurality of heat sinks, the contact surface of the passive cooling structure is formed by individual contact surfaces of the heat sinks. If there is only a single heat sink, the contact surface of the passive cooling structure is formed by an individual contact surface of the single heat sink.

In the first embodiment of the solar module according to the present application, each of the heat sinks is made of a material that has a specific electrical resistance of at least $10^{11}$ ohm•m, so that no high electrical insulation layer is required to electrically isolate the heat sinks from the rear glass. The heat sinks are preferably bonded directly (without an intermediate layer) to the surface of the rear glass away from the solar cells. In this way, the heat sinks themselves ensure that the resistance area product, that is, the product of an electrical contact resistance and contact area between the passive cooling structure and the rear glass, is larger than $4 \times 10^{11}$ ohm•$cm^2$, which is a comparatively simple design solution. For this purpose, each of the heat sinks is preferably made of a high electrically insulating ceramic material or a polymer with a ceramic filler. The ceramic material is at least one of AlN, $Al_2O_3$, $Si_3N_4$, MgO and BN. The polymer is selected from materials made of a polyetheretherketone (PEEK) or polyamide 66 (PA66) with a filler made of BN, $Al_2O_3$ or $SiO_2$.

The core concept of the first embodiment of the solar module according to the present application is to achieve the above presented requirements from a small group of suitable materials. The simulation has shown that the thermal resistance at low weight is not decided by the individual values of thermal conductivity and density, but the ratio of thermal conductivity and density. There are some selected materials, which have a sufficient large ratio of heat conduction and density and have a very high specific resistance. These materials include certain ceramic materials such as AlN, $Si_3N_4$ and $Al_2O_3$. Furthermore, there are relatively new types of thermally conductive, high insulating plastics. These plastics are generated by adding a ceramic filler to a polymer matrix. The one or more heat sinks should be made of a material that has a ratio of thermal conductivity and density of at least 0.02 W•$cm^2$/(g•K), preferably 0.05 W•$cm^2$/(g•K).

In the second embodiment of the solar module according to the present application, the passive cooling structure comprises one or more heat sinks. The heat sinks are each attached, preferably bonded to the surface of the rear glass away from the solar cells by means of a high electrical insulation layer made of a material that has a specific electrical resistance of at least $10^{11}$ ohm•m. The heat sinks are therefore each in thermal contact with the rear glass via the high electrical insulation layer. The individual contact surface of each heat sink is thus connected to the rear glass via the insulation layer.

The insulation layer is preferably designed analogously to the contact surface of the passive cooling structure. If the passive cooling structure comprises only a single heat sink, the insulation layer preferably has the same size as the contact surface of the single heat sink. If the passive cooling structure comprises a plurality of heat sinks, the insulation layer is only disposed on the individual contact surfaces of the heat sinks, i.e. the insulation layer is not provided at a position at which there is no individual contact surface of a heat sink. Alternatively, it is also possible that the insulation layer is also disposed at a position at which there is no contact surface between the passive cooling structure and the rear glass.

The PID effect can be effectively prevented by the insulation layer. In this case, the heat sinks are each made of a material that is inexpensive, readily available and easy to process, and has no high electrically insulating property.

The core concept of the second embodiment of the solar module according to the present application is to achieve the above presented requirements by applying different layers with different materials on the surface of the rear glass of the solar module away from the solar cells. The passive cooling structure is connected to the rear glass of the solar module by a high electrical insulation layer. The insulation layer may, for example, be a silicone adhesive with a high insulation resistance and sufficient thickness. The insulation layer may advantageously be a thicker film made of silicone or ionomers. The resistance of the high insulation layer should not decrease by a factor of more than two, from room temperature to 85 °C. Alternatively, the insulation layer may be a thin layer made of a ceramic material with good thermal conductivity, such as AlN, $Al_2O_3$, BN or $Si_3N_4$. The thin layer is then connected to the rear glass by, for example, a very thin adhesive layer.

Therefore, the material for the insulation layer is advantageously selected from a high insulating ceramic material or a polymer with a ceramic filler. The ceramic material is at least one of AlN, $Al_2O_3$, $Si_3N_4$, MgO and BN, and the polymer is selected from materials made of a polyetheretherketone (PEEK) or polyamide 66 (PA66) with BN, $Al_2O_3$ or $SiO_2$. Alternatively, the insulation layer may be also made of silicone, in particular, in the form of a silicone adhesive or a silicone film. The heat sinks may each be bonded to the rear glass through the silicone film. If the high electrical insulation layer is not formed by the adhesive, the heat sinks are each bonded to the high electrical insulation layer by an adhesive layer, and the insulation layer in turn is bonded to the rear glass. In general, the adhesive layer has a much lower electrical resistance, thus the electrical resistance of the high electrical insulation layer is important.

The heat sinks are each advantageously made of a metallic material, in particular aluminum, copper and/or a magnesium alloy, and/or graphite. These materials are inexpensive, readily available and can be easily processed by conventional methods. In the second embodiment, the heat sinks should be made of a material that has a ratio of thermal conductivity and density of at least $0.02\ \text{W}\cdot\text{cm}^2/(\text{g}\cdot\text{K})$, preferably $0.05\ \text{W}\cdot\text{cm}^2/(\text{g}\cdot\text{K})$.

The passive cooling structure comprises one or more (three-dimensional) heat sinks. Each of the heat sinks has a base surface (i.e. an individual contact surface) on which it is in thermal contact with the rear glass and enables the solar module to be cooled by thermal conduction.

The surface of the passive cooling structure away from the rear glass is enlarged in relation to the contact surface (i.e. the sum of the individual contact surfaces of the plurality of heat sinks) and is dimensioned in such a way that the area ratio of the surface of the passive cooling structure to the contact surface is at least 3. A ratio of 3, for example, means that the surface of the passive cooling structure away from the rear glass is 3 times larger than the contact surface of the passive cooling structure. As a result, the efficient cooling of the solar module can be achieved with sufficient mechanical stability of the passive cooling structure. The area ratio of the surface of the passive cooling structure away from the rear glass to the contact surface is preferably at least 5, in particular preferably larger than 7.

To enlarge the surface, the heat sinks advantageously have a flat base and protrusions that protrude from the base, such as ribs or pins, respectively. A rib or fin has an elongated shape with the long dimension (length) within the plane of the solar module and two much shorter dimensions (height and thickness). A pin has an elongated shape with the longer dimension perpendicular to the plane of the solar module (height) and two smaller dimensions parallel to the plane of the solar module. The heat transfer between the rear glass and each of the heat sinks is performed on the flat base. The flat base of each of the heat sinks forms the base surface (i.e. individual contact surface) of the heat sink for heat transfer.

An adhesive layer for bonding the heat sinks to the rear glass or an adhesive layer for bonding a high electrical insulation layer to the heat sinks or the rear glass is not a decisive factor for the heat transfer and is generally negligible.

In principle, the protrusions may be in any shape, preferably ribs or pins. The ribs with one long dimension within the plane of the solar module may achieve the best cooling with air flow in one direction. The space between two ribs provide a channel-like structure for the flowing air. The pins have a slightly lower cooling efficiency, but allow bi-directional cooling. It will be important, if the same type of modules is installed vertically on a facade of a building, in such a way that an axis of the module in the longitudinal direction is parallel (longitudinal format) and perpendicular (landscape format) to a vertical axis of the building. The bi-directional cooling can also lead to a more uniform temperature distribution. The modifications of these geometries by the tapering of the longitudinal section or other cross-sections are also possible. In the case of cooling ribs, the most important structural parameters, which determine both the enlarged surface and the mass area density, include the distance between two adjacent ribs, the thickness of the cooling ribs, the height of the cooling ribs and the thickness of the base. In the case of cooling pins, the most important structural parameters include the distance and the thickness in the second spatial dimension, in addition to the above parameters.

The heat transfer by convection is largely determined by the thickness of an air boundary layer that is formed on the surface of the heat sink. The distance between the pins or the ribs should be at least 0.5 mm, preferably at least 1 mm, in particular preferably at least 2 mm. The base must transfer the heat to the cooling ribs or cooling pins. Therefore, a comparatively small thickness is sufficient. Furthermore, depending on the design, the base has a mechanical function to hold the cooling ribs or cooling pins together. However, the base is inefficient in terms of mass reduction.

The protrusions such as cooling ribs or cooling pins advantageously have a thickness of smaller than 2 mm, preferably smaller than 1 mm, preferably smaller than 0.5 mm, preferably smaller than 0.2 mm and in particular preferably smaller than 0.08 mm, respectively, and a thickness of the base of each heat sink is smaller than 0.2 mm, preferably smaller than 0.1 mm and in particular preferably smaller than 0.05 mm. These dimension requirements advantageously ensure efficient cooling of the solar module with a low mass area density.

In the above-mentioned first embodiment of the solar module according to the present application, the distance between the cooling ribs or the cooling ribs should be at least 0.5 mm, preferably at least 1 mm, in particular preferably at least 2 mm. The thickness of each of the cooling ribs or cooling pins should be smaller than 2 mm, preferably smaller than 1 mm and in particular preferably smaller than 0.5 mm. The aspect ratio of height to thickness of the cooling ribs or cooling pins should be larger than 20, preferably larger than 40. The thickness of the base is advantageously larger than that in the second embodiment of the solar module according to the present application, since the base is used for electrical insulation and must meet the high requirements for the resistance area product. The thickness of the base of the above-mentioned first embodiment should be smaller than 2 mm, preferably smaller than 1 mm, in particular preferably smaller than 0.7 mm.

A number of cooling structures were simulated. For this purpose, a one-dimensional model for a cooling rib was expanded to include a periodic arrangement of these cooling ribs or pins on a base. The specified sizes depend on various assumptions, in particular on the assumed heat transfer coefficient between the cooling rib surface and the air. The heat transfer coefficient depends on the nature of the surface and the local flow conditions. For example, a mean value of the heat transfer coefficient is 15 W/(m$^2$•K). This example is only used to illustrate a structure that is feasible in principle. For calculations, a solar module of 1m$^2$ is assumed with target values, that is, a total heat transfer coefficient of 50 W/(m$^2$•K) and a total mass of the heat sink of smaller than 4 kg per 1m$^2$, i.e. a mass area density of 0.4g/cm$^2$. A thermal resistance of 0.0001 K/W was assumed for the bond and the interface with the glass, and a thermal conduction resistance of 0.0025 K/W for the rear glass. The examples may also be applied to other module dimensions. The pins and other geometrical shapes are also possible. Table 2 shows a monolithic heat sink with ribs made of various thermally conductive, high insulating materials:

Table 2

| Material | Polymer | Al$_2$O$_3$ | Si$_3$N$_4$ | AlN | MgO |
|---|---|---|---|---|---|
| Thickness of base of heat sink (cm) | 0.18 | 0.05 | 0.08 | 0.05 | 0.05 |
| Thickness of cooling rib (cm) | 0.05 | 0.03 | 0.02 | 0.02 | 0.02 |
| Distance between cooling ribs (cm) | 0.4 | 0.6 | 0.6 | 0.6 | 0.6 |
| Height of cooling rib (cm) | 0.8 | 0.9 | 0.9 | 0.8 | 0.9 |
| The number of cooling ribs | 144 | 103 | 105 | 105 | 105 |
| Thermal resistance of heat sink (K/W) | 0.0174 | 0.0179 | 0.0182 | 0.0184 | 0.0176 |
| Thermal resistance of solar module (K/W) | 0.0199 | 0.0204 | 0.0207 | 0.0209 | 0.0201 |
| Heat transfer coefficient of solar module W/(m$^2$•K) | 50 | 49 | 48 | 48 | 50 |
| Area ratio of the surface of cooling structure to the contact surface | 4.6 | 3.9 | 3.9 | 3.6 | 3.9 |
| Aspect ratio of | 16 | 30 | 45 | 40 | 45,0 |
| height to thickness | | | | | |
| Mass area density (g/cm$^2$) | 0.39 | 0.37 | 0.37 | 0.26 | 0.28 |
| Resistance area product (Ohm•cm$^2$) | 7.2E+12 | 5.0E+12 | 8.0E+12 | 5.0E+12 | 2.5E+13 |

Similar considerations are suitable for the above-mentioned second embodiment of the solar module according to the present application. Preferred materials for the at least one heat sink are metals with an optimal ratio of thermal conductivity and specific weight and an acceptable raw material cost, such as aluminum, copper, magnesium alloy. Further, the graphite is also suitable for the heat sink. The thickness of each of the cooling ribs or cooling pins should be smaller than 0.5 mm, preferably smaller than 0.2 mm and in particular preferably smaller than 0.08 mm. The aspect ratio of height to thickness of the cooling ribs or cooling pins should be larger than 10, preferably larger than 20 and smaller than 200, in particular preferably larger than 20 and smaller than 100, for the necessary mechanical stability. The thickness of the base of the passive cooling structure in the second embodiment should be smaller than 1 mm, preferably smaller than 0.5 mm, in particular preferably smaller than 0.2 mm.

Simulations were performed for various cooling structures. The examples only serve to illustrate the structures that are feasible in principle. For calculations, a solar module of 1m$^2$ was assumed with the target values, that is, a total heat transfer coefficient of 50 W/(m$^2$•K) and a total mass of the heat sink of 3kg per 1m$^2$, i.e. a mass area density (mass per unit area) of 0.3g/cm$^2$. It is assumed that a heat conduction resistance of the insulation layer is 0.005 K/W and a heat conduction resistance of the rear glass is 0.0025 K/W. In order to achieve the necessary insulation, for example, an adhesive (such as silicone) having a specific resistance of $1 \times 10^{13}$ ohm•cm, a thickness of 1 mm and a density of about 1 g/cm$^3$ is used as the insulation layer. This increases the total mass per unit area of the passive cooling structure by 0.1 g/cm$^2$ to 0.4 g/m$^2$. The examples can also be transferred to other module dimensions, since the absorbed heat is directly proportional to the module dimension. The person skilled in the art can convert the parameters based on a mass area density and the resistance area product. Tables 3-5 shows some examples of heat sinks made of some materials.

Table 3: Examples of heat sinks with ribs made of aluminum

| Material | Al | Al | Al | Al |
|---|---|---|---|---|
| Thickness of base of heat sink (cm) | 0.03 | 0.03 | 0.02 | 0.01 |

(continued)

| Material | Al | Al | Al | Al |
|---|---|---|---|---|
| Thickness of cooling rib (cm) | 0.03 | 0.03 | 0.04 | 0.05 |
| Distance between cooling ribs (cm) | 0.6 | 1.1 | 0.4 | 0.7 |
| Height of cooling rib (cm) | 1.5 | 2.5 | 0.9 | 1.5 |
| The number of cooling ribs | 103 | 58 | 148 | 87 |
| Thermal resistance of heat sink (K/W) | 0.0116 | 0.0129 | 0.0128 | 0.0132 |
| Thermal resistance of solar module (K/W) | 0.0189 | 0.0202 | 0.0201 | 0.0205 |
| Heat transfer coefficient of solar module W/($m^2$•K) | 53 | 50 | 50 | 49 |
| Area ratio of the surface of cooling structure to the contact surface | 5.8 | 5.4 | 5.1 | 5.0 |
| Aspect ratio of height to thickness | 50 | 83 | 23 | 30 |

Table 4: Examples of heat sinks with ribs made of other metals

| Material | Cu | Graphite | Mg Alloy | Steel | Zinc | Titanium |
|---|---|---|---|---|---|---|
| Thickness of base of heat sink (cm) | 0.01 | 0.04 | 0.05 | 0.01 | 0.01 | 0.02 |
| Thickness of cooling rib (cm) | 0.01 | 0.04 | 0.05 | 0.01 | 0.012 | 0.02 |
| Distance between cooling ribs (cm) | 0.4 | 0.4 | 0.5 | 0.4 | 0.8 | 0.37 |
| Height of cooling rib (cm) | 0.9 | 1 | 1.2 | 1.1 | 2.1 | 0.9 |
| The number of cooling ribs | 159 | 148 | 118 | 159 | 80 | 167 |
| Thermal resistance of heat sink (K/W) | 0.0122 | 0.0119 | 0.0125 | 0.0121 | 0.0129 | 0.0132 |
| Thermal resistance of solar module (K/W) | 0.0195 | 0.0192 | 0.0198 | 0.0194 | 0.0203 | 0.0205 |
| Heat transfer coefficient of solar module W/($m^2$•K) | 51 | 52 | 51 | 52 | 49 | 49 |
| Area ratio of the surface of cooling structure to the contact surface | 5.4 | 5.5 | 5.4 | 6.4 | 6.2 | 5.6 |
| Aspect ratio of height to thickness | 90 | 25 | 24 | 110 | 175 | 45 |

Table 5: Examples of heat sinks with pins

| Material | Al | Cu | Graphite | Mg | Zinc | Titanium |
|---|---|---|---|---|---|---|
| Thickness of base of heat sink (cm) | 0.01 | 0.01 | 0.05 | 0.01 | 0.01 | 0.01 |
| Thickness of cooling pin (cm) | 0.1 | 0.021 | 0.07 | 0.1 | 0.026 | 0.049 |
| Distance between cooling pins (cm) | 0.3 | 0.2 | 0.3 | 0.35 | 0.2 | 0.2 |
| Height of cooling pin (cm) | 1.6 | 2.6 | 2.1 | 3 | 2.4 | 1.6 |
| The number of cooling pins | 64188 | 210274 | 75018 | 50716 | 201073 | 165642 |
| Thermal resistance of heat sink (K/W) | 0.0132 | 0.013 | 0.013 | 0.011 | 0.014 | 0.014 |
| Thermal resistance of solar module (K/W) | 0.021 | 0.021 | 0.020 | 0.019 | 0.021 | 0.022 |
| Heat transfer coefficient of solar module W/($m^2$•K) | 49 | 48 | 50 | 54 | 47 | 46 |
| Area ratio of the surface of cooling structure to the contact surface | 5.0 | 5.5 | 5.7 | 6.9 | 5.9 | 6.1 |
| Aspect ratio of height to thickness | 16 | 124 | 50 | 30 | 92 | 33 |

The thicknesses of the cooling ribs or cooling pins, the distance between the cooling ribs or cooling pins and the heights of the cooling ribs or cooling pins, i.e. the total volume of the cooling ribs or cooling pins, are limited by the upper limit of the mass. The heat sinks cannot be arranged as densely as desired due to the convection conditions for the distance between the heat sinks. A close-meshed grid acts like a thermal insulator, as the air cannot flow well in the grid. On the one hand, the base distributes the heat from the gaps to the cooling ribs or cooling pins; and on the other hand, the base must also ensure the mechanical cohesion of the structure. The thickness of the base is critical as the base itself does not contribute to cooling, but to the overall mass.

A large surface of the passive cooling structure is created with a large aspect ratio and thin cooling ribs or cooling pins. The enlargement of the surface substantially determines the cooling effect. However, the dimensions of the cross-section should not be too small; otherwise, they can no longer distribute the heat over the entire surface up to the upper ends of the cooling ribs or cooling pins. In the case of the cooling pins, the lower limit for the ratio of thermal conductivity to density is larger. For example, the cooling ribs or cooling pins made of steel and titanium could no longer be realized with a given mass area density and a desired heat transfer coefficient without violating the condition for the distance between the cooling ribs or cooling pins. The cooling ribs or cooling pins are best implemented with materials having highest ratios of thermal conductivity to density such as aluminum, magnesium alloys, graphite or even silicon. The silicon is out of the question for reasons of cost. The cooling ribs or cooling pins made of heavy elements such as copper or zinc must have a very high aspect ratio, since the cooling ribs or cooling pins must be very thin due to large weight of the heavy elements.

The passive cooling structure may include one or more heat sinks. The heat sinks are individually shaped and spatially separated from one another. A plurality of heat sinks are advantageously arranged in such a way that a distance between two heat sinks is at least 0.1 mm, preferably 0.1mm-1mm. The plurality of heat sinks can be used to compensate for stresses due to different temperature coefficients of the glass and the material of the heat sinks. They can also be advantageous for production and bonding. Therefore, it is not necessary to produce the heat sinks as a large, continuous block.

In the above-mentioned second embodiment of the solar module according to the present application, the passive cooling structure can be severed several times in the lateral direction, at least in one dimension, up to the insulation layer or up to the rear glass. The width of the trenches formed by severing the passive cooling structure should be in the range from 0.1mm to 1 mm. This reduces the requirements for the insulation layer, since the entire passive cooling structure is no longer a coherent, low-resistance conductor. If, for example, the heat sink is connected to an installation element at a lower-resistance point by means of a local contact bridge, there is no need for the connection to exist over the entire module surface.

The solar module is preferably a frameless solar module and may be connected to an assembly structure, for example, via supports (back rails) located at the rear glass. In general, the solar module may have one or more installation elements (e.g. back rails, module supports or frame). Preferably, a distance between the passive cooling structure and each installation element for mounting the solar module is 1mm to 20mm, preferably 2mm-20mm, which can achieve good electrical insulation. Back rails are preferred as installation elements.

An embodiment of the present application provides a method for producing a solar module, according to independent claim 13 comprising: providing a front glass and a rear glass, which are fixedly connected to one another by at least one intermediate layer, wherein a plurality of solar cells connected in series being arranged between the front glass and the rear glass; and bonding a passive cooling structure with one or more heat sinks to a surface of the rear glass away from the plurality of solar cells. The method is applicable to the solar module according to any of the embodiments of the present application.

The method advantageously comprises attaching at least one installation element for mounting the solar module to the solar module in such a way that a distance between each heat sink closest to the installation element and the installation element is 1 mm to 20 mm, preferably 2mm-20mm.

An embodiment of the present application provides the use of the solar module according to independent claim 14, as part of a ventilated facade of a building. If there are multiple solar modules at a distance of a few centimeters from a wall, conductive air flows for the solar modules add up. Therefore, the cooling by means of pure natural convection (free-standing solar module without wind) can be achieved by force convection even with very low external wind strength: the heat released by the respective cooling structures rises upward and the cool air enters from below. The air flow then cools the solar modules via the respective cooling structures. For this, sufficient air slots must be disposed at the lower and upper edge of the facade.

By means of the above embodiments, the solar module with the passive cooling structure according to the present application can advantageously achieve high efficient cooling of the solar module, and thus significantly reduce a temperature-induced loss of power. In addition, the PID effect and the associated power loss of the solar module can be avoided. Furthermore, the additional cooling structure only causes a relatively small increase in the weight of the solar module, so that the solar module can be installed with conventionally used installation elements

The various embodiments of the present application can be implemented individually or in any combination. In particular, the features mentioned above and to be explained below can be used not only in the specified combinations, but also in other combinations or individually, without departing from the scope of the present application.

**Brief Description of the Drawings**

The present application is explained in more detail below on the basis of exemplary embodiments and the accompanying figures, which are showed simply and are not drawn to scale:

Fig.1 shows a cross-section of a solar module with a passive cooling structure according to a first embodiment of the present application;

Fig.2 shows a cross-section of a solar module with a passive cooling structure according to a second embodiment of the present application;

Fig.3 shows a cross-section of a solar module with a passive cooling structure according to a third embodiment of the present application;

Fig.4 is a back view of the solar module shown in Fig.3;

Fig.5 shows a cross-section of cooling ribs or cooling pins of the passive cooling structure according to an embodiment of the present application;

Fig.6 shows a perspective view of cooling ribs or cooling pins of the passive cooling structure according to an embodiment of the present application; and

Fig.7 is a flowchart of a method for producing a solar module with a passive cooling structure according to an embodiment of the present application.

**Detailed Description**

In order to make the objectives, technical solutions, and advantages of the present application clearer and more understandable, the present application will be described in detail below with reference to the appended drawings and embodiments. Obviously, the described embodiments are only some, and not all, of the embodiments of the present application. All other embodiments obtained based on the embodiments of the present disclosure by those skilled in the art fall into the scope of protection defined by the present disclosure.

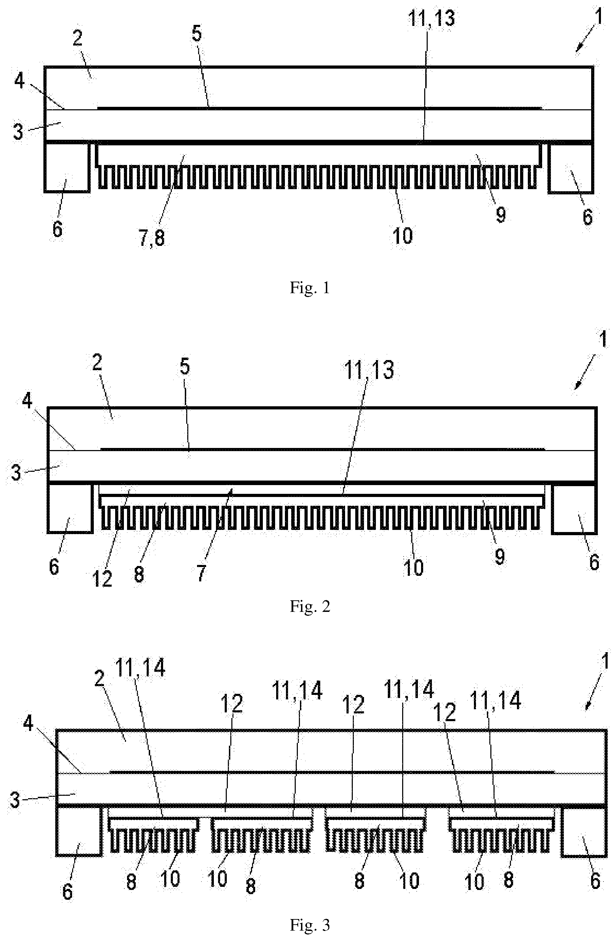

Fig.1 shows a cross-section of a solar module with a passive cooling structure according to a first embodiment of the present application. The above general features of the solar module of the present application, in particular features that are described in connection with the first embodiment, may be provided in Fig. 1.

In Fig. 1, the solar module 1 comprises a front glass 2 and a rear glass 3, which are fixedly connected to one another via at least one intermediate layer 4, for example, a thermoplastic intermediate layer, preferably by lamination. Solar cells 5 connected in series are arranged between the front glass 2 and the rear glass 3 and serve to convert sun's rays into electrical energy. The front glass 2 forms the front side of the solar module 1, that is, the light entry side, through which the sun's rays enter the solar module. The rear glass 3 forms the back side of the solar module 1 opposite to the light entry side.

A passive cooling structure 7 is arranged on a surface of the rear glass 3 away from the solar cells 5. The passive cooling structure 7 has a contact surface 13 at which the passive cooling structure 7 is in thermal contact with the rear glass 3 for heat transfer. An area ratio of a surface of the cooling structure 7 away from the rear glass 3 and the contact surface 13 is at least 3, preferably at least 5, and in particular preferably larger than 7.

The passive cooling structure 7 may include one or more heat sinks 8. In Fig. 1, the passive cooling structure 7 consists of a single heat sink 8, which is fixedly connected to the rear glass 3 in thermal contact with the latter. For example, the heat sink 8 is bonded to the surface of the rear glass 3 away from the solar cells 5 by an adhesive (not shown in Fig. 1). The heat sink 8 includes a base 9 and a plurality of protrusions 10 which protrude from the base 9, such as cooling ribs or cooling pins. For example, the cooling ribs may be arranged on the base 9 parallel to one another and each extend over the entire length of the base 9. For example, the cooling pins may be arranged evenly distributed over the entire base 9. The heat sink 8 is monolithic (i.e., formed in one piece or integrally).

The base 9 of the heat sink 8 is an uninterrupted, contiguous region of the heat sink 8, which is here, for example, in the shape of a cuboid. The cooling ribs or cooling pins protrude from the base 9 in a direction facing away from the rear glass 3. The base 9 has an uninterrupted, contiguous (here, for example, rectangular) base surface 11 for heat transfer between the rear glass 3 and the heat sink 8. The heat sink 8 is bonded directly to the surface of the rear glass 3 away from the solar cells by an adhesive layer (not shown). The base surface 11 forms the contact surface 13 of the passive cooling structure 7 for the heat transfer between the rear glass 3 and the heat sink 8.

The base surface 11 of the base 9 has substantially the same size as the entire area of the solar cells 5. That is, the base surface 11 has substantially the same size or the same size of the photovoltaically active surface of the solar module 1.

The passive cooling structure 7 is a three-dimensional cooling structure with an enlarged surface, which is created by the cooling ribs or cooling pins. The enlarged surface means that the area of the surface of the passive cooling structure 7 away from the rear glass 3 is larger than the area of the base surface 11 of the base 9 or the contact surface 13. The area ratio of the surface of the passive cooling structure 7 away from the rear glass 3 to the base surface 11 is at least 3, preferably at least 5, and in particular larger than 7.

The heat sink 8 may be made of a material that has a ratio of thermal conductivity and density of at least 0.02 $W \cdot cm^2/(g \cdot K)$, preferably at least 0.05 $W \cdot cm^2/(g \cdot K)$ for good heat transfer.

The heat sink 8 may be made of a light, high electrical insulating and high thermal conductive material. For example, the material is selected from a high insulating ceramic material or high insulating, thermal conductive polymer. The ceramic material may be for example at least one of AlN, $Al_2O_3$, $Si_3N_4$, MgO and BN. The polymer may be selected from, for example, materials made of polyetheretherketone (PEEK) or polyamide 66 (PA66) with various fillers such as BN, $Al_2O_3$ or $SiO_2$. It is important for the material of the heat sink 8 that it is an electrical insulator with a specific electrical resistance of at least $10^{11}$ ohm·m.

The heat sink 8 is a part of the passive cooling structure 7 which, via the enlarged surface, ensures convective heat transfer to the environment.

The solar module 1 further includes one or more installation elements 6 (e.g. back rails or back rails), which are located at outer edges of the rear glass 3. The installation elements 6 are fixedly connected to the rear glass 3. The installation elements 6 are used for mechanical fastening of the solar module 1. The passive cooling structure 7 is spaced from the installation elements. Specifically, the heat sink 8 is spatially spaced from the installation elements 6. The distance between the heat sink 8 and the installation elements 6 is 1mm to 20mm, preferably 2 mm to 20mm.

Fig.2 shows a cross-section of a solar module 1 with a passive cooling structure according to a second embodiment of the present application. In order to avoid unnecessary repetition, only the differences from the solar module shown in Fig. 1 are described.

In the solar module 1 of Fig.2, the passive cooling structure 7 includes a single heat sink 8. In addition, a high electrical insulation layer 12 is provided between the heat sink 8 and the rear glass 3. The heat sink 8 is connected to the rear glass 3 via the insulation layer 12. The insulation layer 12 extends completely over the base surface 11 or contact surface 13 of the base 9.

The insulation layer 12 is a high electrical insulation layer which is made of a material having a specific electrical resistance of at least $10^{11}$ ohm·m. The insulation layer 12 may have a thickness of 1mm or less. Since the thickness of the insulation layer 12 is 1 mm or less, there is no high requirements on the thermal conductivity of the insulation layer 12. The insulation layer 12 electrically isolates the heat sink 8 from the rear glass 3, so that the heat sink 8 is highly electrically insulated with respect to the rear glass 3.

The insulation layer 12 may be made of any one of a ceramic material, a polymer with a ceramic filler and a silicone. For example, the ceramic material may be at least one of AlN, $Al_2O_3$, $Si_3N_4$, MgO, BN and so on, the polymer may be selected from materials made of a polyetheretherketone (PEEK) or a polyamide 66 (PA66) with BN, $Al_2O_3$ or $SiO_2$, and the silicone may be a silicone adhesive or a silicone film.

For example, the insulation layer 12 is made of a silicone adhesive with a high insulation resistance and sufficient thickness. A thicker film made of silicone or ionomers may also be used for the insulation layer 12. The insulation layer 12 made of the silicone adhesive is self-adhesive, so there is no need for a further adhesive layer. If the insulation layer 12 is not self-adhesive, respective adhesive layers must be provided on both sides of the insulation layer 12. The electrical properties and heat transfer properties of the adhesive layers are of secondary importance in the context of the present application and therefore do not need to be taken into account. The insulation layer 12 may be also made of a high thermally conductive and high electrically insulating ceramic material, such as AlN, $Al_2O_3$, BN or $Si_3N_4$. The thickness of the insulation layer 12 is 1 mm, for example.

In the embodiment, all materials having a ratio of thermal conductivity and density of at least 0.02 $W \cdot cm^2/(g \cdot K)$, preferably at least 0.05 $W \cdot cm^2/(g \cdot K)$, are suitable as materials for the heat sink 8. These materials do not need to be high electrically insulating. Therefore, these materials may include metals such as aluminum, copper or a magnesium alloy, in addition to the aforementioned materials for the heat sink 8. Furthermore, the heat sink 8 may be made of graphite. Such materials are inexpensive, readily available and easy to process.

Fig.3 shows a cross-section of a solar module 1 with a passive cooling structure according to a third embodiment of the present application. In order to avoid unnecessary repetition, only the differences from the solar module shown in Fig. 2 are described.

In contrast to the embodiment shown in Fig. 2, the passive cooling structure 7 includes a plurality of heat sinks 8. For example, in Fig.3, the passive cooling structure 7 includes four heat sinks 8. Further, the passive cooling structure 7 may include a larger or smaller number of heat sinks 8. The number of the heat sinks and the dimensions of the respective heat sinks 8 can be selected arbitrarily based on the actual requirements. The plurality of heat sinks 8 are spaced apart from one another. For example, a distance between directly adjacent heat sinks 8 is 0.1 mm to 1 mm. The division of the passive cooling structure 7 into the plurality of heat sinks 8 can be advantageous for the manufacturing process. The contact surface 13 of the passive cooling structure 7 is formed by the combination of the individual contact surfaces 14 or base surfaces 11 of the plurality of heat sinks 8. It is also possible to design the insulation layer 12 as a continuous layer without interruptions between the heat sinks 8, such as the two left heat sinks 8 shown in Fig.3. The insulation layer 12 is also located between the adjoining heat sinks 8.

Furthermore, in Fig.3, the installation elements 6 (e.g. back rails or back rails) are spaced from the passive cooling structure 7. Specifically, a distance between one of the plurality of heat sinks 8 closet to one of the installation elements and the one installation element is 1mm to 20mm, preferably 2 mm to 20mm.

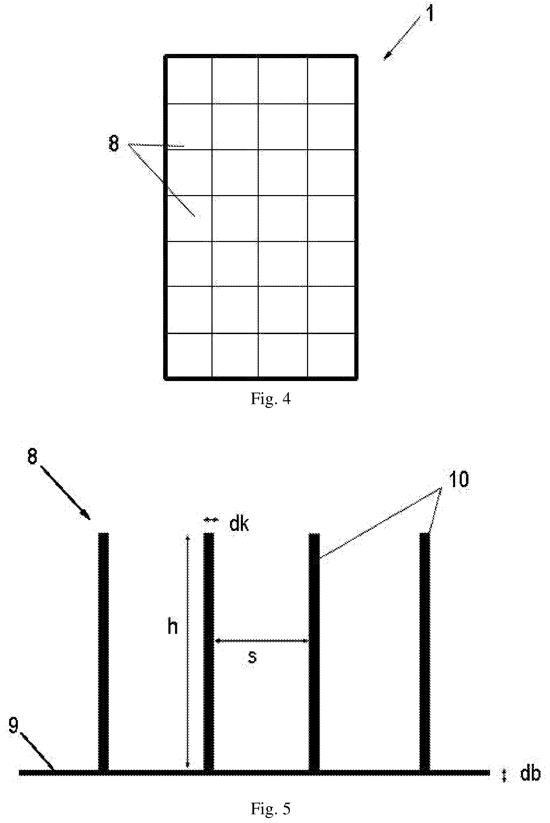

In the embodiment, the plurality of heat sinks 8 may be arranged in a grid. Fig.4 shows an example of such a grid-like structure formed by the plurality of heat sinks 8 on the rear glass 3. The installation elements 6 are not shown in Fig. 4.

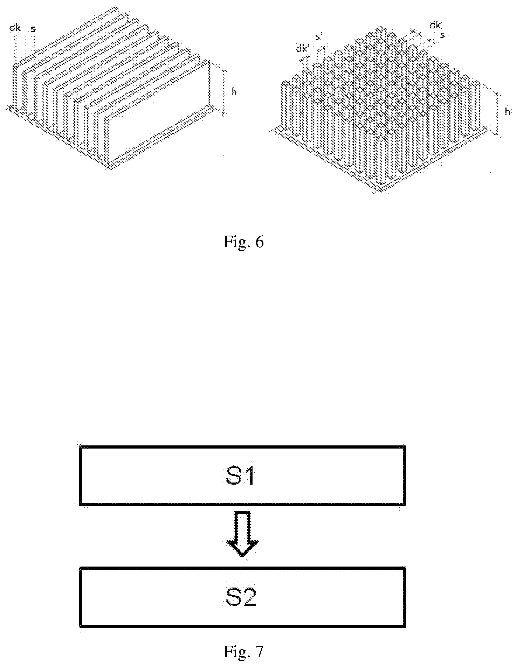

Fig. 5 shows a cross-section of cooling ribs or cooling pins of the passive cooling structure according to an embodiment of the present application. A single heat sink 8 is shown in Fig. 5. As already stated, the heat sink 8 has a base 9 and protrusions 10, such as cooling ribs or cooling pins. Fig. 6 shows a perspective view of cooling ribs or cooling pins of the passive cooling structure according to an embodiment of the present application. The left part of Fig.6 illustrates a single heat sink having a plurality of cooling ribs, and the right part of Fig.6 illustrates a single heat sink having a plurality of cooling pins.

If the protrusions 10 are the cooling ribs, the cooling ribs are arranged parallel to one another on the base 9, as shown in the left part of Fig.6. The cooling ribs protrude from the base 9 in a direction away from the rear glass 3 and substantially perpendicular to the rear glass 3, and each have a height h and a thickness dk. A distance between adjacent cooling ribs is s. The thickness of the base 9 is denoted by db. If the passive cooling structure 7 has a pin structure with cooling pins, that is, the protrusions 10 are the cooling pins, there are a distance s' and a thickness dk' in a second spatial dimension, in addition to the above parameters, as shown in the right part of Fig.6. In the case of a (symmetrical) arrangement of the cooling pins, the distance s' is equal to the distance s and the thickness dk' is equal to the thickness dk. However, the present application is not limited to the symmetrical arrangement of the cooling pins. In general, the heat sinks 8 are designed symmetrically, which has an advantageous of inexpensive and simple manufacture.

In general, the distance s or s' between directly adjacent cooling ribs or cooling pins is at least 0.5 mm, preferably at least 1 mm and in particular preferably at least 2 mm.

In the embodiment of Fig.1, the cooling ribs or cooling pins each have a thickness dk of smaller than 2 mm, preferably smaller than 1 mm and in particular preferably smaller than 0.5 mm. The height h of each of the cooling ribs or cooling pins is determined by the ratio of height h to thickness dk, which is referred to as the aspect ratio. The aspect ratio is larger than 20 and smaller than 200, preferably larger than 40 and smaller than 100. For example, for a cooling rib or cooling pin with the thickness dk of 0.5 mm and the aspect ratio of 20, the height h of the cooling rib or cooling pin is 10 mm.

If the heat sink 8 is connected to the rear glass 3 via the insulation layer 12, as shown in Fig.2, the cooling ribs or cooling pins may each have, for example, a thickness dk of smaller than 0.5 mm, preferably smaller than 0.2 mm and in particular preferably smaller than 0.08 mm. The thickness db of the base 9 is, for example, smaller than 0.2 mm, preferably smaller than 0.1 mm and in particular preferably smaller than 0.05 mm. The aspect ratio is, for example, larger than 10 and less 200, preferably larger than 20 and smaller than 200, in particular preferably larger than 20 and smaller than 100. For example, for a cooling rib or a cooling pin with the thickness dk of 0.2 mm and the aspect ratio of 20, the height h of the cooling rib or cooling pin is 4 mm.

Fig.7 shows a flowchart of a method for producing the solar module 1 with the passive cooling structure 7 according to an embodiment. The method comprises steps S1 and S2.

At S1, the front glass 2 and the rear glass 3 are provided, wherein the front glass and the rear glass are fixedly connected to one another by at least one intermediate layer 4, and a plurality of solar cells 5 connected in series are arranged between the front glass 2 and the rear glass 3.

At S2, the passive cooling structure 7 with one or more heat sinks 8 is bonded to a surface of the rear glass away from the solar cells 5.

The passive cooling structure 7 has a contact surface 13 at which the passive cooling structure 7 is in thermal contact with the rear glass 3 for heat transfer. The contact surface 13 covers at least 90% of a photovoltaically active surface of the solar module 1.

An area ratio of a surface of the cooling structure 7 away from the rear glass 3 and the contact surface 13 is at least 3, preferably at least 5, and in particular preferably larger than 7.

Each of the one or more heat sinks 8 is made of a material that has a ratio of thermal conductivity and density of at least 0.02 W•cm$^2$/(g•K), preferably at least 0.05 W•cm$^2$/(g•K).

The passive cooling structure 7 has a mass area density that is a mass of the passive cooling structure 7 per contact area, and that is smaller than 0.6 g/cm$^2$, preferably smaller than 0.5 g/cm$^2$, and in particular preferably smaller than 0.4 g/cm$^2$.

A resistance area product of the passive cooling structure 7 that is a product of an electrical contact resistance and a contact area between the passive cooling structure 7 and the rear glass 3 is larger than $4\times10^{11}$ ohm•cm$^2$, preferably larger than $2\times10^{12}$ ohm•cm$^2$, and in particular preferably larger than $1\times10^{13}$ Ohm•cm$^2$.

By means of the above embodiments, the solar module with the passive cooling structure according to the present application can advantageously achieve high efficient cooling of the solar module, and thus significantly reduce a temperature-induced loss of power. In addition, the PID effect and the associated power loss of the solar module can be avoided. Furthermore, the additional cooling structure only causes a relatively small increase in the weight of the solar module, so that the solar module can be installed with conventionally used installation elements.

List of reference symbols

| | |
|---|---|
| 1 | solar module |
| 2 | front glass |
| 3 | rear glass |
| 4 | intermediate layer |
| 5 | solar cells |
| 6 | installation element |
| 7 | cooling structure |
| 8 | heat sinks |
| 9 | base |
| 10 | protrusion (cooling rib or cooling pin) |
| 11 | (single) base surface |
| 12 | insulation layer |
| 13 | contact surface |
| 14 | single contact surface |

**Claims**

1. A solar module (1) comprising a front glass (2) and a rear glass (3), which are fixedly connected to one another by at least one intermediate layer (4), wherein a plurality of solar cells (5) connected in series are arranged between the front glass (2) and the rear glass (3), and a passive cooling structure (7) with one or more heat sinks (8) is arranged on a surface of the rear glass (3) away from the plurality of solar cells (5), **characterized in that**:

   the passive cooling structure (7) has a contact surface (13) at which the passive cooling structure (7) is in thermal contact with the rear glass (3) for heat transfer, wherein the contact surface (13) covers at least 90% of a photovoltaically active surface of the solar module (1);
   an area ratio of a surface of the passive cooling structure (7) away from the rear glass (3) and the contact surface (13) is at least 3, preferably at least 5, and in particular preferably larger than 7;
   each of the one or more heat sinks is made of a material that has a ratio of thermal conductivity and density of at least 0.02 W•cm$^2$/(g•K), preferably at least 0.05 W•cm$^2$/(g•K);
   the passive cooling structure (7) has a mass area density that is a mass of the passive cooling structure (7) per contact area, and that is smaller than 0.6 g/cm$^2$, preferably smaller than 0.5 g/cm$^2$, and in particular preferably smaller than 0.4 g/cm$^2$;
   a resistance area product of the passive cooling structure (7) that is a product of an electrical contact resistance and a contact area between the passive cooling structure (7) and the rear glass (3) is larger than $4\times10^{11}$ ohm•cm$^2$, preferably larger than $2\times10^{12}$ ohm•cm$^2$, and in particular preferably larger than $1\times10^{13}$ Ohm•cm$^2$.

2. The solar module (1) of claim 1, wherein each of the one or more heat sinks (8) is made of a material that has a specific electrical resistance of at least $10^{11}$ ohm•m.

3. The solar module (1) of claim 2, wherein the material is selected from a ceramic material or a polymer with a ceramic filler, wherein the ceramic material is at least one of AlN, $Al_2O_3$, $Si_3N_4$, MgO and BN, and the polymer is selected from materials made of a polyetheretherketone (PEEK) or a polyamide 66 (PA66) with BN, $Al_2O_3$ or $SiO_2$.

4. The solar module (1) of claim 1, further comprising a high electrical insulation layer (12) that is made of a material that has a specific electrical resistance of at least $10^{11}$ ohm•m, and that is arranged between the one or more heat sinks (8) and the rear glass (3).

5. The solar module (1) of claim 4, wherein the material for the high electrical insulation layer (12) is any one of a ceramic material, a polymer with a ceramic filler and a silicone, wherein the ceramic material is at least one of AlN, $Al_2O_3$, $Si_3N_4$, MgO and BN, the polymer is selected from materials made of a polyetheretherketone (PEEK) or a polyamide 66 (PA66) with BN, $Al_2O_3$ or $SiO_2$, and the silicone is a silicone adhesive or a silicone film.

6. The solar module (1) of claim 4, wherein each of the one or more heat sinks (8) is made of a metallic material and/or graphite, the metallic material being at least one of aluminum, copper and magnesium alloy.

7. The solar module (1) of claim 1, wherein each of the one or more heat sinks (8) has a base (9) and protrusions (10) protruding from the base, wherein the heat transfer between the rear glass (3) and the one or more heat sinks (8) is performed at the base (9).

8. The solar module (1) of claim 7, wherein each of the protrusions (10) has a thickness of smaller than 2 mm, preferably smaller than 1 mm, preferably smaller than 0.5 mm, preferably smaller than 0.2 mm and in particular preferably smaller than 0.08 mm, a distance between adjacent protrusions in the protrusions (10) is at least 0.5 mm, preferably at least 1 mm and in particular preferably at least 2 mm, and the base (9) has a thickness of smaller than 0.2 mm, preferably smaller than 0.1 mm and in particular preferably smaller than 0.05 mm.

9. The solar module (1) of claim 7, wherein, the protrusions are cooling ribs or cooling pins.

10. The solar module (1) of claim 1, wherein a distance between two adjacent sinks in the one or more heat sinks (8) is 0.1mm to 1mm.

11. The solar module (1) of claim 1, wherein a distance between a heat sink (8) closest to an installation element (6) for mounting the solar module (1) and the installation element (6) is 1mm to 20mm.

12. The solar module (1) of claim 1, wherein a heat transfer coefficient of the solar module (1) is at least 20 W/(K•m$^2$).

13. A method for producing a solar module (1) according to any one of claims 1 to 12, comprising:

providing a front glass (2) and a rear glass (3) which are fixedly connected to one another by at least one intermediate layer (4), wherein a plurality of solar cells (5) connected in series are arranged between the front glass (2) and the rear glass (3),
bonding a passive cooling structure (7) with one or more heat sinks (8) to a surface of the rear glass (3) away from the plurality of solar cells (5), wherein:

the passive cooling structure (7) has a contact surface (13) at which the passive cooling structure (7) is in thermal contact with the rear glass (3) for heat transfer, wherein the contact surface (13) covers at least 90% of a photovoltaically active surface of the solar module (1);
an area ratio of a surface of the passive cooling structure (7) away from the rear glass (3) and the contact surface (13) is at least 3, preferably at least 5, and in particular preferably larger than 7;
each of the one or more heat sinks is made of a material that has a ratio of thermal conductivity and density of at least 0.02 W•cm$^2$/(g•K), preferably at least 0.05 W•cm$^2$/(g•K);
the passive cooling structure (7) has a mass area density that is a mass of the passive cooling structure (7) per contact area, and that is smaller than 0.6 g/cm$^2$, preferably smaller than 0.5 g/cm$^2$, and in particular preferably smaller than 0.4 g/cm$^2$;
a resistance area product of the passive cooling structure (7) that is a product of an electrical contact resistance and a contact area between the passive cooling structure (7) and the rear glass (3) is larger than $4\times10^{11}$ ohm•cm$^2$, preferably larger than $2\times10^{12}$ ohm•cm$^2$, and in particular preferably larger than $1\times10^{13}$ Ohm•cm$^2$.

14. Use of a solar module (1) according to one of claims 1 to 12 as part of a ventilated facade of a building.

**Patentansprüche**

1. Solarmodul (1), umfassend ein vorderes Glas (2) und ein hinteres Glas (3), die durch mindestens eine Zwischenschicht (4) fest miteinander verbunden sind, wobei eine Vielzahl von Solarzellen (5), die in Reihe verbunden sind, zwischen dem vorderen Glas (2) und dem hinteren Glas (3) angeordnet ist und eine passive Kühlstruktur (7) mit einer oder mehreren Wärmesenken (8) auf einer Fläche des hinteren Glases (3) entfernt von der Vielzahl von Solarzellen (5) angeordnet ist, **dadurch gekennzeichnet, dass**:

   die passive Kühlstruktur (7) eine Kontaktfläche (13) aufweist, an der die passive Kühlstruktur (7) zur Wärmeübertragung im thermischen Kontakt mit dem hinteren Glas (3) steht, wobei die Kontaktfläche (13) mindestens 90 % einer photovoltaisch aktiven Fläche des Solarmoduls (1) abdeckt;
   ein Flächenverhältnis einer Fläche der von dem hinteren Glas (3) und der Kontaktfläche (13) entfernten passiven Kühlstruktur (7) mindestens 3, bevorzugt 5, beträgt und besonders bevorzugt größer als 7 ist;
   jede der einen oder der mehreren Wärmesenken aus einem Material besteht, das ein Verhältnis von Wärmeleitfähigkeit und Dichte von mindestens 0,02 $W\bullet cm^2/(g\bullet K)$, bevorzugt mindestens 0,05 $W\bullet cm^2/(g\bullet K)$, aufweist;
   die passive Kühlstruktur (7) eine Massenflächendichte aufweist, die eine Masse der passiven Kühlstruktur (7) pro Kontaktfläche ist und die kleiner als 0,6 $g/cm^2$, bevorzugt kleiner als 0,5 $g/cm^2$ und besonders bevorzugt kleiner als 0,4 $g/cm^2$, ist;
   ein Widerstandflächenprodukt der passiven Kühlstruktur (7), das ein Produkt aus einem elektrischen Kontaktwiderstand und einer Kontaktfläche zwischen der passiven Kühlstruktur (7) und dem hinteren Glas (3) ist, größer als $4\times10^{11}$ $Ohm\bullet cm^2$, bevorzugt größer als $2\times10^{12}$ $Ohm\bullet cm^2$ und besonders bevorzugt größer als $1\times10^{13}$ $Ohm\bullet cm^2$, ist.

2. Solarmodul (1) nach Anspruch 1, wobei jede der einen oder der mehreren Wärmesenken (8) aus einem Material besteht, das einen spezifischen elektrischen Widerstand von mindestens $10^{11}$ $Ohm\bullet m$ aufweist.

3. Solarmodul (1) nach Anspruch 2, wobei das Material aus einem Keramikmaterial oder einem Polymer mit einem Keramikfüllstoff ausgewählt ist, wobei das Keramikmaterial mindestens eines von AIN, $Al_2O_3$, $Si_3N_4$, MgO und BN ist und das Polymer aus Materialen ausgewählt ist, die aus Polyetheretherketon (PEEK) oder Polyamid 66 (PA66) mit BN, $Al_2O_3$ oder $SiO_2$ bestehen.

4. Solarmodul (1) nach Anspruch 1, ferner umfassend eine Schicht (12) mit hoher elektrischer Isolation, die aus einem Material besteht, das einen spezifischen elektrischen Widerstand von mindestens $10^{11}$ $Ohm\bullet m$ aufweist und das zwischen der einen oder den mehreren Wärmesenken (8) und dem hinteren Glas (3) angeordnet ist.

5. Solarmodul (1) nach Anspruch 4, wobei das Material für die Schicht (12) mit hoher elektrischer Isolation ein beliebiges aus einem Keramikmaterial, einem Polymer mit einem Keramikfüllstoff und einem Silikon ist, wobei das Keramikmaterial mindestes eines von AIN, $Al_2O_3$, $Si_3N_4$, MgO und BN ist, das Polymer aus Materialen ausgewählt ist, die aus Polyetheretherketon (PEEK) oder Polyamid 66 (PA66) mit BN, $Al_2O_3$ oder $SiO_2$ bestehen, und das Silikon ein Silikonklebemittel oder ein Silikonfilm ist.

6. Solarmodul (1) nach Anspruch 4, wobei jede der einen oder der mehreren Wärmesenken (8) aus einem metallischen Material und/oder Graphit besteht, wobei das metallische Material mindestens eines von Aluminium, Kupfer und einer Magnesiumlegierung ist.

7. Solarmodul (1) nach Anspruch 1, wobei jede der einen oder mehreren Wärmesenken (8) eine Basis (9) und Vorsprünge (10), die von der Basis vorstehen, aufweist, wobei die Wärmeübertragung zwischen dem hinteren Glas (3) und der einen oder den mehreren Wärmesenken (8) an der Basis (9) durchgeführt wird.

8. Solarmodul (1) nach Anspruch 7, wobei jeder der Vorsprünge (10) eine Dicke kleiner als 2 mm, bevorzugt kleiner als 1 mm, bevorzugt kleiner als 0,5 mm, bevorzugt kleiner als 0,2 mm und besonders bevorzugt kleiner als 0,08 mm, aufweist, ein Abstand zwischen benachbarten Vorsprüngen in den Vorsprüngen (10) mindestens 0,5 mm, bevorzugt mindestens 1 mm und besonders bevorzugt mindestens 2 mm beträgt und die Basis (9) eine Dicke kleiner als 0,2 mm, bevorzugt kleiner als 0,1 mm und besonders bevorzugt kleiner als 0,05 mm aufweist.

9. Solarmodul (1) nach Anspruch 7, wobei die Vorsprünge Kühlrippen oder Kühlstifte sind.

10. Solarmodul (1) nach Anspruch 1, wobei ein Abstand zwischen zwei benachbarten Senken in der einen oder den mehreren Wärmesenken (8) 0,1 mm bis 1 mm beträgt.

11. Solarmodul (1) nach Anspruch 1, wobei ein Abstand zwischen einer Wärmesenke (8), die sich am nächsten zu einem Installationselement (6) zum Montieren des Solarmoduls (1) befindet, und dem Installationselement (6) 1 mm bis 20 mm beträgt.

12. Solarmodul (1) nach Anspruch 1, wobei ein Wärmeübertragungskoeffizient des Solarmoduls (1) mindestens 20 W/(K•m$^2$) beträgt.

13. Verfahren zum Herstellen eines Solarmoduls (1) nach einem der Ansprüche 1 bis 12, umfassend:

Bereitstellen eines vorderen Glases (2) und eines hinteren Glases (3), die durch mindestens eine Zwischenschicht (4) fest miteinander verbunden sind, wobei eine Vielzahl von Solarzellen (5), die in Reihe verbunden sind, zwischen dem vorderen Glas (2) und dem hinteren Glas (3) angeordnet ist,

Anheften einer passiven Kühlstruktur (7) mit einer oder mehreren Wärmesenken (8) an eine Fläche des hinteren Glases (3) entfernt von der Vielzahl von Solarzellen (5), wobei:

die passive Kühlstruktur (7) eine Kontaktfläche (13) aufweist, an der die passive Kühlstruktur (7) zur Wärmeübertragung im thermischen Kontakt mit dem hinteren Glas (3) steht, wobei die Kontaktfläche (13) mindestens 90 % einer photovoltaisch aktiven Fläche des Solarmoduls (1) abdeckt;

ein Flächenverhältnis einer Fläche der von dem hinteren Glas (3) und der Kontaktfläche (13) entfernten passiven Kühlstruktur (7) mindestens 3, bevorzugt 5, beträgt und besonders bevorzugt größer als 7 ist;

jede der einen oder der mehreren Wärmesenken aus einem Material besteht, das ein Verhältnis von Wärmeleitfähigkeit und Dichte von mindestens 0,02 W•cm$^2$/(g•K), bevorzugt mindestens 0,05 W•cm$^2$/(g•K), aufweist;

die passive Kühlstruktur (7) eine Massenflächendichte aufweist, die eine Masse der passiven Kühlstruktur (7) pro Kontaktfläche ist und die kleiner als 0,6 g/cm$^2$, bevorzugt kleiner als 0,5 g/cm$^2$ und besonders bevorzugt kleiner als 0,4 g/cm$^2$, ist;

ein Widerstandflächenprodukt der passiven Kühlstruktur (7), das ein Produkt aus einem elektrischen Kontaktwiderstand und einer Kontaktfläche zwischen der passiven Kühlstruktur (7) und dem hinteren Glas (3) ist, größer als $4 \times 10^{11}$ Ohm•cm$^2$, bevorzugt größer als $2 \times 10^{12}$ Ohm•cm$^2$ und besonders bevorzugt größer als $1 \times 10^{13}$ Ohm•cm$^2$, ist.

14. Verwendung eines Solarmoduls (1) nach einem der Ansprüche 1 bis 12 als Teil einer belüfteten Fassade eines Gebäudes.

**Revendications**

1. Module solaire (1) comprenant un verre avant (2) et un verre arrière (3), qui sont reliés de manière fixe l'un à l'autre par au moins une couche intermédiaire (4), dans lequel une pluralité de cellules solaires (5) reliées en série sont disposées entre le verre avant (2) et le verre arrière (3), et une structure de refroidissement passive (7) avec un ou plusieurs dissipateurs thermiques (8) est disposée sur une surface du verre arrière (3) éloignée de la pluralité de cellules solaires (5), **caractérisé en ce que** :

la structure de refroidissement passive (7) présente une surface de contact (13) au niveau de laquelle la structure de refroidissement passive (7) est en contact thermique avec le verre arrière (3) pour un transfert de chaleur, dans lequel la surface de contact (13) recouvre au moins 90 % d'une surface active sur le plan photovoltaïque du module solaire (1) ;

un rapport de surface d'une surface de la structure de refroidissement passive (7) éloignée du verre arrière (3) et de la surface de contact (13) est d'au moins 3, de préférence d'au moins 5, et en particulier de préférence supérieur à 7 ;

chacun des un ou plusieurs dissipateurs thermiques est constitué d'un matériau qui a un rapport de conductivité thermique et de densité d'au moins 0,02 W•cm$^2$/(g•K), de préférence d'au moins 0,05 W•cm$^2$/(g•K) ;

la structure de refroidissement passive (7) a une densité surfacique massique qui est une masse de la structure de refroidissement passive (7) par zone de contact, et qui est inférieure à 0,6 g/cm$^2$, de préférence inférieure à 0,5 g/cm$^2$, et en particulier de préférence inférieure à 0,4 g/cm$^2$ ;

un produit de surface de résistance de la structure de refroidissement passive (7) qui est un produit d'une résistance de contact électrique et d'une surface de contact entre la structure de refroidissement passive (7) et le verre arrière (3) est supérieur à $4 \times 10^{11}$ ohm•cm$^2$, de préférence supérieur à $2 \times 10^{12}$ ohm•cm$^2$, et en particulier de préférence supérieur à $1 \times 10^{13}$ ohm•cm$^2$.

2. Module solaire (1) selon la revendication 1, dans lequel chacun des un ou plusieurs dissipateurs thermiques (8) est constitué d'un matériau qui a une résistance électrique spécifique d'au moins $10^{11}$ ohm•m.

3. Module solaire (1) selon la revendication 2, dans lequel le matériau est choisi parmi un matériau céramique ou un polymère avec une charge céramique, dans lequel le matériau céramique est au moins l'un parmi AIN, $Al_2O_3$, $Si_3N_4$, MgO et **BN,** et le polymère est choisi parmi des matériaux constitués d'une polyétheréthercétone (PEEK) ou d'un polyamide 66 (PA66) avec BN, $Al_2O_3$ ou $SiO_2$.

4. Module solaire (1) selon la revendication 1, comprenant en outre une couche d'isolation électrique élevée (12) qui est constituée d'un matériau qui a une résistance électrique spécifique d'au moins $10^{11}$ ohm•m, et qui est disposée entre les un ou plusieurs dissipateurs thermiques (8) et le verre arrière (3).

5. Module solaire (1) selon la revendication 4, dans lequel le matériau pour la couche d'isolation électrique élevée (12) est l'un quelconque parmi un matériau céramique, un polymère avec une charge céramique et un silicone, dans lequel le matériau céramique est au moins l'un parmi AIN, $Al_2O_3$, $Si_3N_4$, MgO et BN, le polymère est choisi parmi les matériaux constitués d'une polyétheréthercétone (PEEK) ou d'un polyamide 66 (PA66) avec BN, $Al_2O_3$ ou $SiO_2$ , et le silicone est un adhésif de silicone ou un film de silicone.

6. Module solaire (1) selon la revendication 4, dans lequel chacun des un ou plusieurs dissipateurs thermiques (8) est constitué d'un matériau métallique et/ou de graphite, le matériau métallique étant au moins un alliage d'aluminium, de cuivre et de magnésium.

7. Module solaire (1) selon la revendication 1, dans lequel chacun des un ou plusieurs dissipateurs thermiques (8) comporte une base (9) et des saillies (10) faisant saillie à partir de la base, dans lequel le transfert de chaleur entre le verre arrière (3) et les un ou plusieurs dissipateurs thermiques (8) est effectué au niveau de la base (9).

8. Module solaire (1) selon la revendication 7, dans lequel chacune des saillies (10) a une épaisseur inférieure à 2 mm, de préférence inférieure à 1 mm, de préférence inférieure à 0,5 mm, de préférence inférieure à 0,2 mm et en particulier de préférence inférieure à 0,08 mm, une distance entre des saillies adjacentes dans les saillies (10) est d'au moins 0,5 mm, de préférence d'au moins 1 mm et en particulier de préférence d'au moins 2 mm, et la base (9) a une épaisseur inférieure à 0,2 mm, de préférence inférieure à 0,1 mm et en particulier de préférence inférieure à 0,05 mm.

9. Module solaire (1) selon la revendication 7, dans lequel les saillies sont des nervures de refroidissement ou des broches de refroidissement.

10. Module solaire (1) selon la revendication 1, dans lequel une distance entre deux dissipateurs adjacents dans les un ou plusieurs dissipateurs thermiques (8) est de 0,1 mm à 1 mm.

11. Module solaire (1) selon la revendication 1, dans lequel une distance entre un dissipateur thermique (8) le plus proche d'un élément d'installation (6) pour le montage du module solaire (1) et l'élément d'installation (6) est de 1 mm à 20 mm.

12. Module solaire (1) selon la revendication 1, dans lequel un coefficient de transfert de chaleur du module solaire (1) est d'au moins 20 W/(K•m$^2$).

13. Procédé de fabrication d'un module solaire (1) selon l'une quelconque des revendications 1 à 12, comprenant :

la fourniture d'un verre avant (2) et d'un verre arrière (3) qui sont reliés de manière fixe l'un à l'autre par au moins une couche intermédiaire (4), dans lequel une pluralité de cellules solaires (5) reliées en série sont disposées entre le verre avant (2) et le verre arrière (3),
la liaison d'une structure de refroidissement passive (7) avec un ou plusieurs dissipateurs thermiques (8) à une surface du verre arrière (3) éloignée de la pluralité de cellules solaires (5), dans lequel :

la structure de refroidissement passive (7) présente une surface de contact (13) au niveau de laquelle la structure de refroidissement passive (7) est en contact thermique avec le verre arrière (3) pour un transfert de chaleur, dans lequel la surface de contact (13) recouvre au moins 90 % d'une surface active sur le plan photovoltaïque du module solaire (1) ;

un rapport de surface d'une surface de la structure de refroidissement passive (7) éloignée du verre arrière (3) et de la surface de contact (13) est d'au moins 3, de préférence d'au moins 5, et en particulier de préférence supérieur à 7 ;

chacun des un ou plusieurs dissipateurs thermiques est constitué d'un matériau qui a un rapport de conductivité thermique et de densité d'au moins 0,02 W•cm$^2$/(g•K), de préférence d'au moins 0,05 W•cm$^2$/(g•K) ;

la structure de refroidissement passive (7) a une densité surfacique massique qui est une masse de la structure de refroidissement passive (7) par zone de contact, et qui est inférieure à 0,6 g/cm$^2$, de préférence inférieure à 0,5 g/cm$^2$, et en particulier de préférence inférieure à 0,4 g/cm$^2$ ;

un produit de surface de résistance de la structure de refroidissement passive (7) qui est un produit d'une résistance de contact électrique et d'une surface de contact entre la structure de refroidissement passive (7) et le verre arrière (3) est supérieur à $4 \times 10^{11}$ ohm•cm$^2$, de préférence supérieur à $2 \times 10^{12}$ ohm•cm$^2$, et en particulier de préférence supérieur à $1 \times 10^{13}$ ohm•cm$^2$.

14. Utilisation d'un module solaire (1) selon l'une des revendications 1 à 12 comme élément d'une façade ventilée d'un bâtiment.

Fig. 1

Fig. 2

Fig. 3

Fig. 4

Fig. 5

Fig. 6

Fig. 7

**EP 4 295 415 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2015004244 A1
- WO 2014075919 A1
- GB 2384113 A

### Non-patent literature cited in the description

- **OLAWOLE et al.** Innovative methods of cooling solar panel: A concise review. *J. Phys.: Conf. Ser.*, 2019, vol. 1299, 012020